# EUROPEAN PATENT APPLICATION

(11) **EP 4 645 623 A1**
(43) Date of publication of application: **05.11.2025**
(21) Application number: 25172693.1
(22) Date of filing: 25.04.2025
(51) Int. Cl.: H02H 9/04, H02H 3/087, H01H 33/59, H03K 17/082

(54) **CIRCUIT BREAKER WITH A PASSIVE CLAMPING CIRCUIT INCLUDING CAPACITORS, OPERATION METHOD, DC NETWORK AND AIRCRAFT**

(30) Priority: 02.05.2024 EP 24173830; 30.09.2024 DE 102024128249
(71) Applicant: Airbus (S.A.S.), 31700 Blagnac (FR)
(72) Inventor: Kapaun, Florian, 82024 Taufkirchen (DE); Steiner, Gerhard, 82024 Taufkirchen (DE); Witti, Michael, 82024 Taufkirchen (DE)
(74) Representative: KASTEL Patentanwälte PartG mbB

(57) **Abstract**

The invention relates to a circuit breaker (14) comprising a main switching unit (16) configured to be switched off in the event of a fault, and a passive clamping circuit (18) for absorbing energy and protecting against overvoltage wherein the clamping circuit (18) is connected in parallel to the main switching unit (16). In order to improve the functionality, it is proposed that the clamping circuit (18) comprises a plurality of passive transient suppression components (20.1, 20.2, 20.3) and delaying means (19) arranged and configured to shift the action of the passive transient compression components (20.1, 20.2, 20.3) so that they respond sequentially rather than simultaneously.

## Description

The invention relates to a circuit breaker, especially for an aircraft, comprising a main switching unit configured to be switched off in the event of a fault, and a clamping circuit for absorbing energy and protecting against overvoltage. Further, the invention relates to an operation method for such circuit breaker. Further, the invention relates to a DC network, such as a DC network of a power distribution system, especially for an aircraft, including such a circuit breaker, and to an aircraft equipped therewith.

For technical background, reference is made to the following literatures:
[1] Wikipedia, "Circuit breaker", download from https://en.wikipedia.org/wiki/Circuit_breaker on February 07, 2024
[2] Wikipedia, "Clamper (electronics)", download from https://en.wikipedia.org/wiki/Clamper_(electronics) on January 10, 2024
[3] WO 2014/177874 A2
[4] WO 2022/272007 A2
[5] L. Camurca, J. Jacobsen and M. Liserre, "Passive Clamping Circuit for Reduced Switch Count in Solid State Circuit Breakers," 2021 IEEE 15th International Conference on Compatibility, Power Electronics and Power Engineering (CPE-POWERENG), 2021
[6] EP 0 701 313 A1
[7] US 11 515 815 B2
[8] CN 204 906 177 U
[9] CN 116 093 912 A
[10] CN 217 156 599 U
[11] CN 104 348 146 B

Literatures [5] and [6] disclose a circuit breaker comprising a main switching unit configured to be switched off in the event of a fault, and a clamping circuit for absorbing energy and protecting against overvoltage wherein the clamping circuit is connected in parallel to the main switching unit and comprises a primary passive protective circuit including a passive transient suppression component. [7] describes an overvoltage clamping circuit which has TVS diodes which break when the voltage exceeds the threshold. [8] describes a voltage clamping device that has TVS diodes as the clamping element. [9] describes a peak voltage clamping circuit that has a TVS tube, TVS diode and a capacitor to control the peak voltage. [10] describes a surge protection circuit having TVS diodes and capacitors for a high-power electronic equipment.

An object of the invention is to provide a circuit breaker with an advanced clamping solution.

For achieving such object, the invention provides a circuit breaker according to claim 1. A DC network and an aircraft with such a circuit breaker are given in the furter independent claims.

Advantageous embodiments are subject-matters of the dependent claims. Further, an operation method for an embodiment of the circuit breaker is provided.

The invention provides according to a first aspect thereof a circuit breaker comprising a main switching unit configured to be switched off in the event of a fault, and a passive clamping circuit for absorbing energy and protecting against overvoltage wherein the clamping circuit is connected in parallel to the main switching unit wherein the clamping circuit comprises a plurality of passive transient suppression components and delaying means arranged and configured to shift the action of the passive transient compression components so that they respond sequentially rather than simultaneously.

In some embodiments, the passive transient suppression components are chosen from the group consisting of a varistor, and a TVS-diode.

In some embodiments, the passive transient suppression components are connected in series.

In some embodiments, the clamping circuit comprises n transient suppression components with n being a natural number greater than two and wherein the delaying means comprises n-1 delaying components, each associated to one of the transient suppression components so that its action is delayed.

In some embodiments, the delaying components are different to each other.

In some embodiments, the delaying components have different values.

In some embodiments, the delaying components are capacitors.

In some embodiments, the delaying components are capacitors with different capacitances.

In some embodiments, the delaying means comprises at least one capacitor connected parallel to one of the transient suppression components.

In some embodiments, the clamping circuit comprises a series connection of first to third transient suppression components and wherein the delaying means comprise a first capacitor connected in parallel to the second transient suppression component and a second capacitor connected in parallel to the third transient suppression component, wherein the capacitances of the first and second capacitors are different to each other.

In some embodiments, the clamping circuit comprises a primary passive protective circuit including the plurality of transient suppression components and wherein the delaying means has at least one primary capacitor configured to be charged during clamping when the main switch is opened,
wherein the clamping circuit further comprises a discharge circuit including at least one secondary capacitor and configured to discharge the at least one primary capacitor when the main switching unit is closed.

In some embodiments, the clamping circuit comprises a plurality of primary capacitors configured to be charged when the main switch unit is opened, and wherein the discharge circuit comprises an arrangement of secondary capacitors and is configured to discharge the primary capacitors when the main switch unit is closed.

In some embodiments, the discharge circuit comprises several decoupling resistors configured to decouple the at least one secondary capacitor from the primary passive protection circuit during clamping.

In some embodiments, the clamping circuit comprises a series of several transient suppression segments each comprising a passive protective circuit unit and a discharge circuit unit connected in parallel to each other, wherein each of the passive protective circuit units includes one passive transient suppression component and wherein at least one or several of the passive protective circuit units additionally include one primary capacitor, and wherein each discharge circuit unit includes one secondary capacitor, wherein the capacitances of the secondary capacitors are selected such that each transient suppression segment has the same charge.

In some embodiments, each transient suppression segment comprises a TVS diode as transient suppression component and a balancing resistor in parallel connection with the secondary capacitor wherein the resistances of the balancing resistors of the transient suppression units are selected such that they are proportional to standoff voltages of the TVS diodes to which they are connected.

In some embodiments, each transient suppression segment comprises at least one of the decoupling resistors for decoupling the passive protection circuit unit from the secondary capacitor during clamping.

According to a further aspect, an operation method for operating the circuit breaker according to those embodiments comprising the discharge circuit, is proposed, the operation method comprising the steps:
a) opening the main switch unit in the event of a fault and applying an entire bus voltage to the clamping circuit; charging the primary and the secondary capacitors until a steady state is reached;
b) closing the main switch unit when the event of a fault is over and short-cutting the clamping circuit, discharging the secondary capacitors and discharging the primary capacitors via the discharge circuit.

In some embodiments, step a) comprises:
a1) decoupling the discharge circuit from the primary passive protective circuit in an initial time after opening the main switch unit by means of the decoupling resistors.

In some embodiments, step a) comprises:
a2) charging the sum of capacitors of each transient suppression segment with the same charge.

In some embodiments, step b) comprises:
b1) limiting the voltage by the transient suppression components so that no further charging occurs and discharging all capacitors to a smaller voltage via the decoupling resistors.

According to another aspect, the invention provides a DC network, especially for a power distribution system, preferably for an aircraft, comprising at least one source of electrical energy and at least one sink for electrical energy and at least one circuit breaker according to any of the preceding embodiments connected between the at least one source and the at least one sink.

According to another aspect, the invention provides an aircraft comprising such a DC network (e.g. as part of a power distribution system) or at least one circuit breaker according to any of aforementioned embodiments.

Preferred uses of embodiments of the invention are power electronics, DC switches and voltage clamping circuits. Embodiments of the invention are suitable for all applications dealing with DC power systems and their protection. Wherever an overcurrent must be shut off, embodiments of the invention are very useful.

Embodiments of the invention provide a solid state circuit breaker (SSCB) comprising a main switching unit configured to be switched off in the event that a current running through the solid state circuit breaker exceeds a maximum current threshold, and a clamping circuit for absorbing energy and protecting against overvoltage.

Embodiments of the invention provide an advanced clamping for minimum voltage overshoot.

Embodiments of the invention implement an advanced clamping solution, especially suitable for aircraft, that allows manipulation of a voltage overshoot. This allows inevitable voltage spikes to be intelligently shifted to mitigate the impact on the grid and reduce the maximum voltages that occur.

Some embodiments make use of standard TVS diodes as clamping elements, but also other similar transient suppression components such as varistors can be implemented.

In some embodiments, a transient voltage is clamped with a clamping circuit including delay means for shifting the action of several transient suppression components. The delay means could be made with any suitable delay component. In some embodiments, capacitors are used as delaying components.

In some embodiments, varistors or TVS diodes are used as transient compression components.

Embodiments of the invention allow to drastically reduce voltage overshoots (inductive during turn-off of the main switch) and TVS-based (during clamping) in failure cases. Due to the passive design, the clamping circuit can be designed in optimal way with minimal weight and outlines.

In some embodiments the indented characteristic of the TVS diodes is utilized by 'switching on' the diodes with a short time delay (realised by the capacitors connected in parallel). In some embodiments, this method is used with a passive circuit utilising the snap-back characteristic of some TVS diodes. In known devices, the diodes are simply connected in series without taking different timing into account and additional 'snubber circuits' are connected in parallel for overvoltage filtering (state of the art; see, e.g. [5] to [11]). The circuit according to preferred embodiments of the invention takes a completely different (intelligent and more effective) approach here.

Some embodiments provide devices and means for discharging the clamping circuit including capacitors quickly after end of an event where transient voltage has been clamped. Thus, the clamping circuit can easily handle a new transient event. Thus, there is no need to throttle a protection circuit.

Preferred embodiments of the invention provide a SSCB that can be safely operated wherein a clamping circuit with less weight and possible high integration is provided. Especially, a bidirectional SSCB with a clamping circuit of less weight is provided. Thus, the SSCB is improved for use on aircraft.

Embodiments of the invention are explained below referring to the accompanying drawings in which:
- Fig. 1: is a schematic plan view of an embodiment of an aircraft with a DC network for a power distribution system comprising semiconductor switch circuit breakers;
- Fig. 2: is a block diagram of a DC network, such as for example the power distribution system of the aircraft of Fig. 1, protected with a semiconductor switch circuit breaker (SSCB) according to a comparative example;
- Fig. 3: is a graph showing voltages and currents for a SSCB according to a comparative example with a passive clamping circuit in the event of a fault;
- Fig. 4: shows the typical (idealized) voltage waveform in the circuit breaker of Fig. 2 after an overcurrent;
- Fig. 5: is a block diagram of a DC network, especially of the aircraft of Fig. 1, protected with a semiconductor switch circuit breaker (SSCB) having a clamping circuit according to a first embodiment of the invention;
- Fig. 6: shows the same simulations as in Fig. 4 but within the circuit of Fig. 5; and
- Fig. 7: is a block diagram of a clamping circuit according to a second embodiment of the invention.

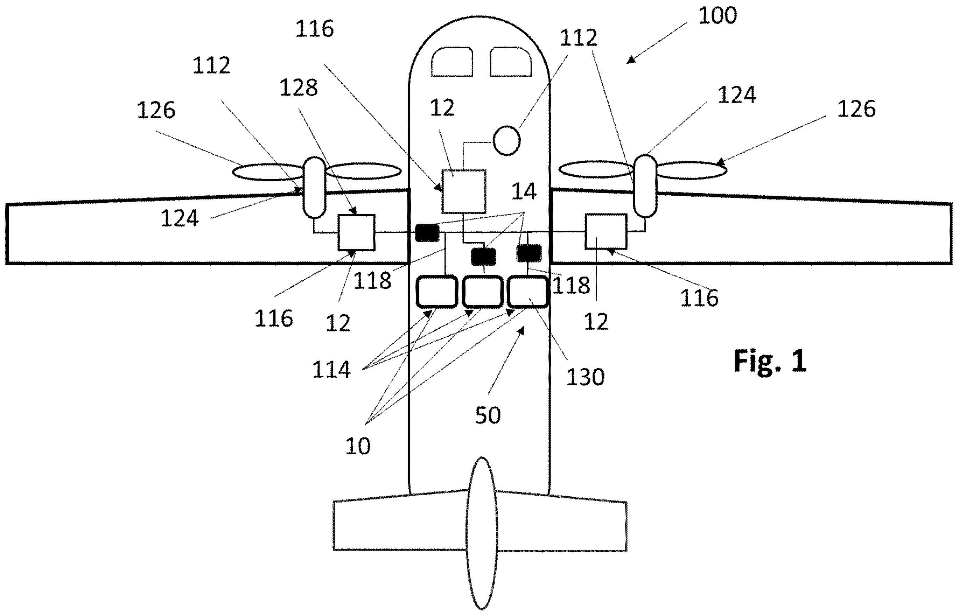

Embodiments of the invention relate to power electronics and especially DC networks 50 and their protection. Especially, embodiments of the invention relate to circuit breakers 14 where transient voltage is clamped with a passive clamping circuit 18 including transient suppression components 20.1, 20.2, 20.3 and a delay means 19 for influencing the switching of these components. Some possible embodiments of the invention are explained, by way of example, referring to a possible use in an aircraft 100 including a DC network 50 such as shown in Fig. 1.

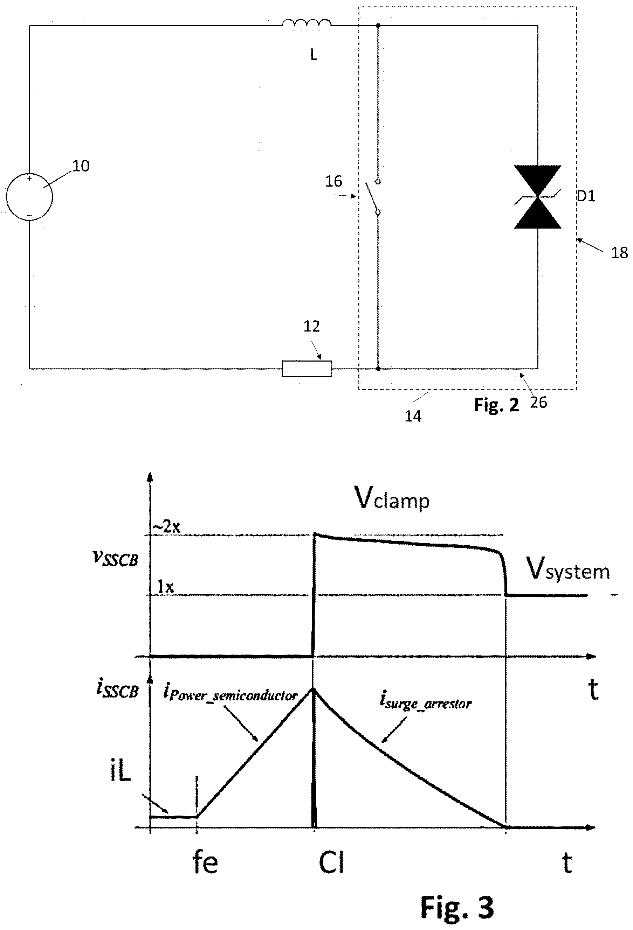

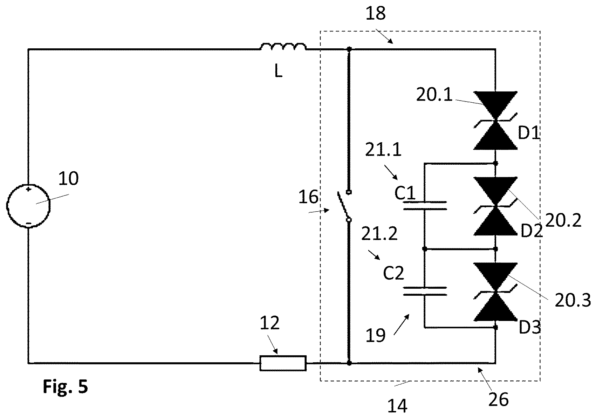

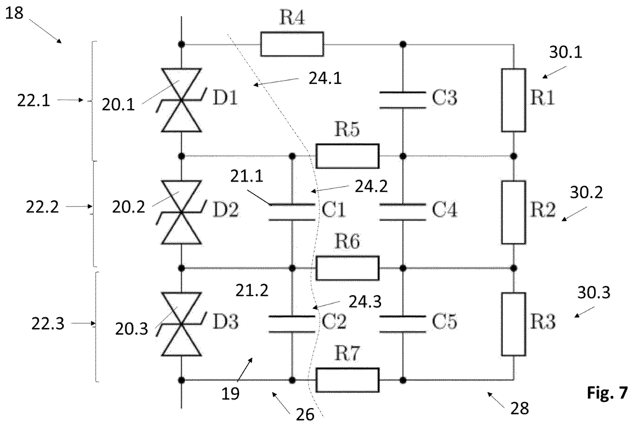

An example for the DC network 50 including a circuit breaker 14, especially a SSCB (solid state circuit breaker) or DC breaker, which comprises a clamping circuit 18 according to a comparative example is shown in Fig. 3. Enhanced clamping circuits 18 according to embodiments of the invention that can be used instead of the clamping circuit 18 of the comparative example are shown in Figs. 5 and 7.

Fig. 1 shows an aircraft 100 with a DC network in the form of a power distribution system protected by circuit breakers 14 such as semiconductor switch circuit breakers (SSCB) or other kind of DC breakers.

The aircraft 100 according to the example shown in Fig. 1 comprises at least one DC energy source 10 providing a DC energy over a dc bus 118 with a dc-bus voltage VDC, at least one power electronic 116 as example for a sink 12 of the DC network 50, and at least one electrical consumer 112 supplied with electrical power from the energy source 10 via the power electronic 116.

The electrical consumer 112 can be of any kind of aircraft component to be powered with AC or DC power such as an electrical actor, a motor pump, or an electric motor 124. In some embodiments, the DC network 50 is part of an electrical propulsion system 120 of the aircraft 100 wherein, for example, the motor 124 is a propulsion motor for driving a flight propulsion element such as a propeller 126 of the aircraft 100.

In some embodiments, the power electronic 116 is an inverter 128 for supplying the electrical consumer 112 with AC power converted from the DC energy source 10 which may be or include a battery 130 or a fuel cell or a DC power network including several batteries 130 and/or fuel cells (not shown).

Fig. 2 shows a block diagram with an exemplary circuit according to a comparative example for a DC network 48 such as the power distribution system 50 of the aircraft of Fig. 1. The DC network 48 may contain single or multiple sources 10 and sinks 12. For simplicity only one source 10 and one device 18 as examples for a bidirectional load such as sources and/or sinks 12 are shown here. Further a line inductance L is indicated. The at least one source 10 provides electrical energy with a system working voltage V_{system} (e.g., the dc bus voltage) and a current i_{SSCB}. The at least one sink 12 is provided with the electrical energy from the source 10 via a solid state circuit breaker (SSCB) 14 connected therebetween. The SSCB 14 comprises a main switching unit 16 (DC breaker) and a clamping circuit 36.

DC networks 48 are becoming increasingly important in modern power supply systems 50. Due to the lack of voltage zero crossing, special considerations must be made to protect the networks in the event of a fault. A central element is the so-called DC breaker, which opens the circuit in the event of a fault. Unfortunately, the inductively stored energy must be dissipated in the process. Rapid opening of the DC breaker leads to high di/di values and thus to high voltage peaks, which without protective measures can lead to the destruction of components in the network. One solution is to limit the overvoltage, i.e., to limit the overvoltage and dissipate the line energy (energy stored in the DC lines (inductance)).

In case of failures, e.g. a short circuit in one of the devices 18, the SSCB 14 acts as a safety device, limiting the fault current and disconnecting the sources 10 and sinks 12. The SSCB 14 comprises the clamping circuit 36 as protective measure against overvoltage.

Fig. 3 shows typical voltages during a switch event of a SSCB according to a comparative example, wherein the SSCB has a conventional passive clamping circuit. State of the art technologies usually use such a passive clamping system, e.g., consisting of TVS diodes, varistors, or the like. The references shown in Fig. 3 mean:
- i_{SSCB}: current over SSCB
- v_{SSCB}: voltage over SSCB
- V_{system}: system working voltage
- V_{clamp}: voltage clamped by surge arrester
- CI: current interruption (power semiconductor = main switching module switches off)
- fe: fault event
- iL: nominal load current
- i_{Power_semiconductor}: current through main switching unit
- i_{surge_arrestor}: current through passive clamping component
- t: time

Common to all these methods is that the components have a very soft characteristic, which means that a relatively large overshoot and high voltages during clamping must be expected. This could become problematic if the systems working voltage V_{system} was close to the maximum permissible operating voltage of the semiconductors, since in the event of a fault this voltage can be exceeded and the components destroyed. Therefore, large semiconductor devices with high maximum permissible operating voltages need to be applied in prior art clamping circuits. In addition, most clamping components have a strong temperature dependence. To avoid high losses during normal operation caused by leakage currents, the clamping voltage is much higher than the max. operating voltage.

Referring again to Fig. 2, there is shown the state of the art of overvoltage limitation with a standard TVS diode D1. In case of a fault, the bidirectional main switch 16 (e.g. MOSFET) opens the circuit and the occurring overvoltage is intercepted by D1.

Unfortunately, D1 is not an ideal component and therefore clamps the voltage relatively softly. This could in some cases lead to a large overshoot with a potential risk to destroy components. Using a TVS with lower breakdown is also not an option, since the voltage must not be below the operating voltage and a certain amount of reverse voltage is required to step down the breakdown current.

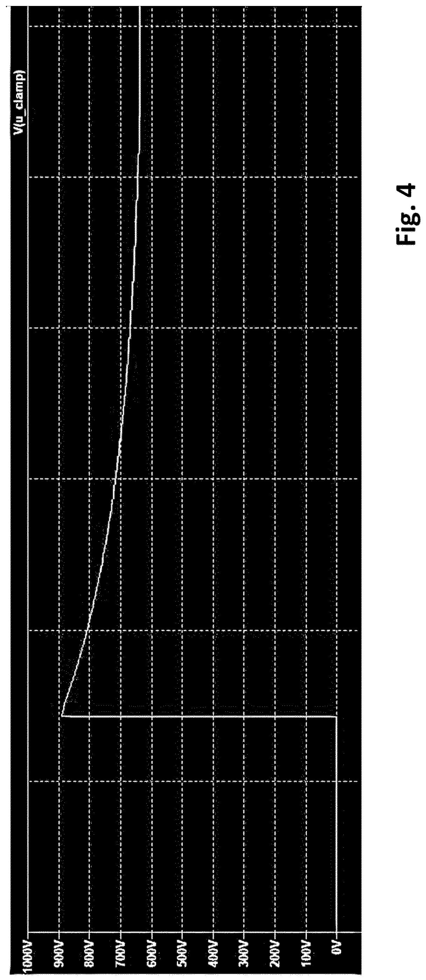

Fig. 4 shows the typical (idealized) voltage waveform after an overcurrent event. This curve does not take into account the inductive overshoot during commutation. It only shows the behaviour of the TVS diode D1, i.e. overshoot (in this case 650 V --+ 900 V) and foldback behaviour (the voltage drops below the nominal clamping voltage of the diode D1). This overshoot leads to major limitations in the design of the protection system.

If more than one TVS diode is used, e.g. to achieve higher voltages or to optimally set the desired clamping value, the overvoltage behaviour of the individual diodes adds up to a total overvoltage, i.e. approximately n*V _overshoot, where n is the number of serial components.

Figs 5 and 7 show block diagrams of circuits with a circuit breaker according to embodiments of the present invention.

The circuit breaker 14 comprises the main switching unit 16 configured to be switched off in the event of a fault, and the passive clamping circuit 18 for absorbing energy and protecting against overvoltage. The clamping circuit 18 is connected in parallel to the main switching unit 16 and comprises a plurality of passive transient suppression components 20.1, 20.2, 20.3 and delaying means 19 arranged and configured to shift the action of the passive transient compression components 20.1, 20.2, 20.3 so that they respond sequentially rather than simultaneously.

The passive transient suppression components 20.1, 20.2, 20.3 could be of any suitable kind, for example varistors could be utilized. In the embodiments shown, the transient suppression components 20.1, 20.2, 20.3 are TVS-diodes D1, D2, D3. In some embodiments, identical transient suppression components 20.1, 20.2, 20.3 are used. For example same TVS diodes may be used, such that D1=D2=D3.

One idea implemented in embodiments of the present invention is to shift the action of the individual diodes D1, D2, D3 so that they respond sequentially rather than simultaneously. This allows the overall peak voltages to be drastically reduced, resulting in a much more efficient clamping circuit design.

The delaying means 19 may be of any suitable kind. In some embodiments, the delaying means 19 has n-1 delaying components 21.1, 21.2, each associated to one of the transient suppression components 20.1, 20.2, 20.3 so that their action is shifted in a sequential order. In the embodiments shown, the delaying components 21.1, 21.2 are capacitors C1, C2, each connected in parallel to one of the TVS diodes D2, D3.

Fig. 5 and 7 show possible implementations of the advanced clamping. A "diode-shift" functionality is realized by the capacitors C1 and C2 connected in parallel, which have different capacitance values.

Fig. 5 shows a block diagram with an exemplary circuit for the DC network 50, e.g. for a power distribution system such as the power distribution system of the aircraft 100 of Fig. 1. The DC network 50 may contain single or multiple sources 10 and sinks 12. For simplicity only one source 10 and only one sink 12 is shown here. The at least one source 10 provides electrical energy with a source voltage VDC (e.g., the dc bus voltage) and a current lin. The at least one sink 12 is provided with the electrical energy from the source 10 via a circuit breaker 14 (e.g., DC breaker, solid state circuit breaker SSCB) connected therebetween. The sink 12 may be a bidirectional load (or a bidirectional source). Further, the line inductance L is indicated in Fig. 5.

In case of a fault, e.g. a short circuit, the circuit breaker 14 acts as a safety device, interrupting the fault current and disconnecting the sources 10 and sinks 12. The circuit breaker 14 has a main switching unit 16 with at least one main electrical switch. In some embodiments, the circuit breaker 14 is a bidirectional SSCB with a bidirectional main switching unit 16 that may include two main electrical switches. The term "electrical switch" is used as a representation of any semiconductor switch such as IGBT, MOSFET, ....

In normal operation, the main switching unit 16 is closed (ON) so that the sink 12 is connected to the source 10 and provided with DC electrical energy with the DC bus voltage VDC with a line current lin.

The main switching unit 32 is configured to be switched off in the event of a fault. Rapid opening of the DC breaker - circuit breaker 14 - leads to high dl/dt values and thus to high voltage peaks, which without protective measures can lead to the destruction of components in the network.

Therefore, the circuit breaker 14 is equipped with the clamping circuit 18 including the transient suppression components 20.1, 20.2, 20.3 such as a varistor, e.g., a MOV, or the TVS diode D1, D2, D3 and the delay means 19, here with primary capacitors C1, C2.

The clamping circuit 18 according to the first embodiment of Fig. 5 constitutes a primary passive protective circuit 26. In the example shown, the primary passive protective circuit 26 includes a first to third passive transient suppression component 20.1, 20.2, 20.3, here for example in form of a first to third TVS diode D1, D2, D3 (e.g., same kind of TVS diodes, D1=D2=D3). The several passive transient suppression components 20.1, 20.2, 20.3 are connected in series. Further, the shown example of the primary passive protective circuit 26 comprises several primary capacitors C1, C2. For example, a first primary capacitor C1 is connected in parallel to the second transient suppression component 20.2, and a second primary capacitor C2 is connected in parallel to the third transient suppression component 20.3. The primary capacitors C1, C2 are example for delaying components of the delay device.

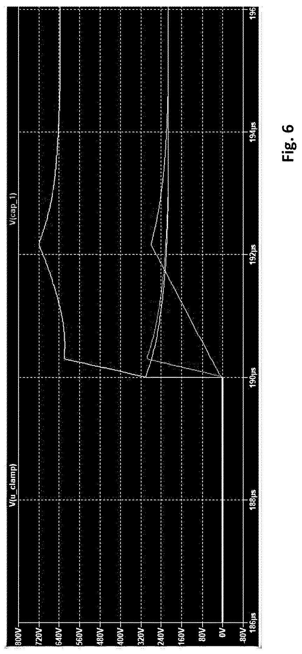

Fig. 6 shows the same simulation as Fig. 4 but with the delay means 19, here embodied by the additionally placed capacitors C1, C2. It can be seen that the voltage peaks of the individual diodes occur with a time delay. Therefore, the total clamping voltage can be drastically reduced (approx. 720V instead of 900V). The estimated results also have been successfully proven in a lab setup.

Embodiments of the invention, such as for example shown in Figs. 5 and 7, enable at least one, several or all of the following improvements over state of art circuits such as shown in Fig. 2:
- Drastic reduction of overvoltage
- Better adjustment of voltage behaviour
- Tighter limits adjustable (→ derating more flexible)
- Better utilization of components
- Very high energy clamping capability at low weight and volume
- Significantly sharper clamping characteristic
- Fast passive discharge → full functionality even with several consecutive malfunctions

The clamping circuit 18 of Fig. 7 includes the protection circuit 26 of Fig. 5 which provides the same functionality as explained with reference to Fig. 5. In the following additional functionalities of the embodiment of Fig. 7 are explained.

The clamping circuit 18 of Fig. 5 is an example for a protective measure to protect the DC network 50 against high peak voltages. The primary protective circuit 16 of the clamping circuit 18 of some embodiments consists of TVS diodes D1, D2, D3 and primary capacitors C1, C2. The capacitors C1, C2 are charged in the event of a fault, when the main switching unit 16 opens.

The capacitors C1, C2, must be discharged after the switch across the diodes D1, D2, D3 is closed to prepare the primary protective circuit 16 for another transient event. This can be done with a discharge resistor (not shown in Fig. 5) on each primary capacitor C1, C2. A resistor value that may be used would be a compromise between the standoff losses (main switch unit 16 is open) and the discharge time once the main switch unit 16 is closed. In a system with a cut-off voltage of 800 V and a cut-off current of 1 kA, typical resistor values generate losses in the single-digit watt range and require several seconds to discharge the primary protective circuit 16. These limitations are not conducive to system performance and reliability.

If a new transient event occurs before the primary capacitors C1, C2 are fully discharged, a significant voltage spike would be generated across the main switching unit 16. The main switching unit 16 must therefore be throttled more than necessary to cope with a fault condition immediately after system start-up.

In order to address this disadvantage, circuit breakers 14 according to some embodiments of the invention have a clamping circuit 18 where an additional capacitor arrangement is added. An example thereof is shown in Fig. 7.

The clamping circuit 18 of circuit breakers 14 according to this further embodiments of the invention has the primary passive protection circuit 26 with the at least one transient suppression component 20.1, 20.2, 20.3 and with the at least one primary capacitor C1, C2, and additionally a discharge circuit 28 including at least one secondary capacitor C3, C4, C5. The discharge circuit 28 is configured to discharge the at least one primary capacitor C1, C2 when the main switching unit 16 is closed.

In the example of Fig. 7, the clamping circuit 18 according to an embodiment of the invention has the primary protection circuit 26 similar to the clamping circuit 18 of the comparative example as shown in Fig. 2, and additionally the discharge circuit 28 in the form of an arrangement of secondary capacitors C3, C4, C5. For example, a series of three secondary capacitors C3, C4, C5 as shown at the right in Fig. 7 is added.

These additional capacitors C3, C4, C5 discharge the primary capacitors C1, C2 when the main switch unit 16 is closed and the voltage at the clamping circuit 18 is close to zero. The clamping performance is not significantly affected by the additional components. This process takes place quite quickly. The exact speed can be set. Further optional implementations are described in the following.

In embodiments of the invention, the required discharge process can be completed in the 50-100 microsecond range instead of taking multiple seconds. The leakage current while the main switch unit 16 is closed is also reduced. The proposed clamping circuit 18 is also completely passive.

In some embodiments, the discharge circuit 26 further comprises several decoupling resistors R4, R5, R6, R7 configured to decouple the at least one secondary capacitor C3, C4, C5 from the primary passive protection circuit 26 during clamping.

In some embodiments, the discharge circuit 26 further comprises several balancing resistors R1, R2, R3. The balancing resistors R1, R2, R3 are configured to balance the charging between transient suppression segments 22.1, 22.2, 22.3 when the switch is turned off. During clamping, the balancing resistors R1, R2, R3 are decoupled via the decoupling resistors R4, R5, R6, R7.

The clamping circuit 18 of Fig. 7 comprises a series of several transient suppression segments 22.1, 22.2, 22.3. Each transient suppression segment 22.1, 22.2, 22.3 comprises a part or segment of the passive protection circuit 26 - which is called a passive protective circuit unit 24.1, 24.2, 24.2 in the following - and a part or segment of the discharge circuit 28 - which is called discharge circuit unit 30.1, 30.2, 30.3 in the following. In each transient suppression segment 22.1, 22.2, 22.3, the respective passive protective unit 24.1, 24.2, 24.3 and the respective discharge circuit unit 30.1, 30.2, 30.3 are connected parallel to each other. Each of the passive protective circuit units 24.1, 24.2, 24.3 includes one passive transient suppression component 20.1, 20.2, 20.3. At least one or several of the passive protective circuit units 24.1, 24.2, 24.3 additionally include one primary capacitor C1, C2. Each discharge circuit unit 30.1, 30.2, 30.3 includes one secondary capacitor C3, C4, C5.

The capacitances of the secondary capacitors C3, C4, C5 are selected such that each transient suppression segment 22.1, 22.2, 22.3 has the same charge.

In the embodiment of Fig. 7, a series of three transient suppression segments 22.1, 22.2, 22.3 is provided. Since each transient suppression segment 22.1, 22.2, 22.3 has, in the example shown, a diode D1, D2, D3 as transient suppression segment, it can also be called diode segment.

R 1, R2, R3 are passive balancing resistors. Their values are proportional to the standoff voltages of the TVS diodes D1, D2, D3 to which they are connected. These balancing resistors R1, R2, R3 can have quite large values depending on the leakage current requirements. As a rule, they can be selected in the upper kilo to megohm range.

R4, R5, R6 and R7 are decoupling resistors. They decouple the diodes D1, D2, D3 and the primary capacitors C1, C2 from the rest of the system during clamping. Their values are typically in the range of 10 Ohm for 1 kV and 500A.

As mentioned above, the capacitances of the additional secondary capacitors C3, C4, C5 are selected so that each diode segment - transient suppression segment 22.1, 22.2, 22.3 has the same charge.

A possible selection of capacitances is explained in more detail in an example. Let us assume, the capacitance of the second primary capacitor C2 has a value which is two times of the capacitance of the first primary capacitor: C2=2 x C1. The diode voltages are taken from the example of Fig. 3, with the values as indicated above. There are several possible solutions: One of them is: C4 must be the same size as C2 and C5 must be the same size as C1. C3 must then be half as large as C1 and C4 together. D1 has twice the voltage of the others, which halves the capacitance of C3 if the charge is to be the same.

In the following, an embodiment of an operation method for the circuit breaker 14 including the clamping circuit 18 of Fig. 7 is explained. Possible steps of the discharge process are:
1. When the main switch unit 16 is open, the entire bus voltage is applied to the clamping circuit 18. After reaching a steady state via the balancing resistors (R1, R2, R3), all capacitors C1-C5 are charged to a voltage close to the standoff voltage of the connected TVS diode D1, D2, D3. During longer time intervals (>1 ms), the decoupling resistors R4 - R7 can be considered approximately as short circuits due to their comparatively small values.
2. After closing the main switch unit 16 and short-circuiting the clamping circuit 18, the charge in all capacitors C1-C5 flows off partly via the diodes D1-D3, but mainly via the decoupling resistors R4 - R7. In the first peak, current flows across the transient supression components, after that the complete current flows across the decoupling resistors R4-R7. As the capacitor charge is the same in each diode segment 22.1, 22.2, 22.3, all capacitors C1-C5 reach approximately 0 V after the discharge process.
3. During the next transient event, the "diode shift" function of the clamping circuit 18 works as expected. The decoupling resistors R4, R5, R6 and R7 decouple the discharge network - discharge circuit 28 - during the short clamping time.

By using the discharge circuit 28 in conjunction with a "diode shift" clamping circuit 18, the discharge time can be reduced from several seconds to the two-digit microsecond range. A transient event during or shortly after activation of the DC network 50 can therefore be intercepted without the switching voltage forming a peak.

Due to the passive nature of the clamping circuit 18, no significant additional complexity is introduced into the system. This reduces integration speed, product development time and facilitates certification.

### Reference sign list:

- 10: energy source/voltage source
- 12: sink
- 14: circuit breaker
- 16: main switching unit
- 18: clamping circuit
- 19: delay means
- 20.1: first transient suppression component
- 20.2: second transient suppression component
- 20.3: third transient suppression component
- 21.1: first delaying component
- 21.2: second delaying component
- 22.1: first transient suppression segment
- 22.2: second transient suppression segment
- 22.3: third transient suppression segment
- 24.1: first passive protective circuit unit
- 24.2: second passive protective circuit unit
- 24.3: third passive protective circuit unit
- 26: primary passive protection circuit
- 28: discharge circuit
- 30.1: first discharge circuit unit
- 30.2: second discharge circuit unit
- 30.3: third discharge circuit unit
- 50: DC network
- 100: aircraft
- 112: electrical consumer
- 116: power electronic
- 118: dc bus
- 120: electrical propulsion system
- 124: motor
- 126: propeller
- 128: inverter
- 130: battery
- D1: first TVS diode
- D2: second TVS diode
- D3: third TVS diode
- C1: first primary capacitor
- C2: second primary capacitor
- C3: first secondary capacitor
- C4: second secondary capacitor
- C5: third secondary capacitor
- L: Line inductance
- R1: first balancing resistor
- R2: second first balancing resistor
- R3: third first balancing resistor
- R4: first decoupling resistor (for decoupling primary protection circuit and discharge circuit during clamping)
- R5: second decoupling resistor (for decoupling primary protection circuit and discharge circuit during clamping)
- R6: third decoupling resistor (for decoupling primary protection circuit and discharge circuit during clamping)
- R7: fourth decoupling resistor (for decoupling primary protection circuit and discharge circuit during clamping)

## Claims

1. Circuit breaker (14) comprising a main switching unit (16) configured to be switched off in the event of a fault, and a passive clamping circuit (18) for absorbing energy and protecting against overvoltage wherein the clamping circuit (18) is connected in parallel to the main switching unit (16) **characterized in that** the clamping circuit (18) comprises a plurality of passive transient suppression components (20.1, 20.2, 20.3) and delaying means (19) arranged and configured to shift the action of the passive transient compression components (20.1, 20.2, 20.3) so that they respond sequentially rather than simultaneously.

2. Circuit breaker (14) according to claim 1, wherein the passive transient suppression components (20.1, 20.2, 20.3) are chosen from the group consisting of a varistor, and a TVS-diode (D1, D2, D3).

3. Circuit breaker (14) according to any of the preceding claims wherein the passive transient suppression components (20.1, 20.2, 20.3) are connected in series.

4. Circuit breaker (14) according to any of the preceding claims wherein the clamping circuit comprises n transient suppression components (20.2, 20.2, 20.3) with n being a natural number greater than two and wherein the delaying means comprises n-1 delaying components (21.1, 21.2), each associated to one of the transient suppression components so that its action is delayed.

5. Circuit breaker according to claim 4, wherein the delaying components (21.1, 21.2)
5.1 are different to each other and/or
5.2 have different values and/or
5.3 are capacitors (C1, C2) with different capacitances.

6. Circuit breaker (14) according to any of the preceding claims wherein the delaying means (19) comprises at least one capacitor (C1, C2) connected parallel to one of the transient suppression components (20.1, 20.2, 20.3).

7. Circuit breaker (14) according to claims 4 to 6, wherein the clamping circuit comprises a series connection of first to third transient suppression components (20.1, 20.2, 20.3) and wherein the delaying means (19) comprise a first capacitor (C1) connected in parallel to the second transient suppression component (20.2) and a second capacitor (C2) connected in parallel to the third transient suppression component, wherein the capacitances of the first and second capacitors (C1, C2) are different to each other.

8. Circuit breaker (14) according to any of the preceding claims, wherein the clamping circuit (18) comprises a primary passive protective circuit (26) including the plurality of transient suppression components (20.1, 20.2, 20.3) and wherein the delaying means has at least one primary capacitor (C1, C2) configured to be charged during clamping when the main switch (16) is opened,
wherein the clamping circuit (18) further comprises a discharge circuit (28) including at least one secondary capacitor (C3, C4, C5) and configured to discharge the at least one primary capacitor (C1, C2) when the main switching unit (16) is closed.

9. Circuit breaker (14) according to claim 8, wherein
9.1 the clamping circuit (18) comprises a plurality of primary capacitors (C1, C2) configured to be charged when the main switch unit (16) is opened, and wherein the discharge circuit (28) comprises an arrangement of secondary capacitors (C3, C4, C5) and is configured to discharge the primary capacitors (C1, C2) when the main switch unit (16) is closed; and/or
9.2 the discharge circuit (28) comprises several decoupling resistors (R4, R5, R6, R7) configured to decouple the at least one secondary capacitor (C3, C4, C5) from the primary passive protection circuit (26) during clamping.

10. Circuit breaker according to any of the claims 8 or 9, wherein the clamping circuit (18) comprises a series of several transient suppression segments (22.1, 22.2, 22.3) each comprising a passive protective circuit unit (24.2, 24.2, 24.3) and a discharge circuit unit (30.1, 30.2, 30.3) connected in parallel to each other,
wherein each of the passive protective circuit units (24.2, 24.2, 24.3) includes one passive transient suppression component (20.2, 20.2, 20.3) and wherein at least one or several of the passive protective circuit units (24.2, 24.2, 24.3) additionally include one primary capacitor (C1, C2), and
wherein each discharge circuit unit (30.1, 30.2, 30.3) includes one secondary capacitor (C3, C4, C5),
wherein the capacitances of the secondary capacitors (C3, C4, C5) are selected such that each transient suppression segment (22.1, 22.2, 22.3) has the same charge.

11. Circuit breaker (14) according to claim 10, wherein each transient suppression segment (22.2, 22.2, 22.3) comprises a TVS diode (D1, D2, D3) as transient suppression component (20.2, 20.3, 20.3) and a balancing resistor (R1, R2, R3) in parallel connection with the secondary capacitor (C3, C4, C5) wherein the resistances of the balancing resistors (R1, R2, R3) of the transient suppression units (22.1, 22.2, 22.3) are selected such that they are proportional to standoff voltages of the TVS diodes (D1, D2, D3) to which they are connected.

12. Circuit breaker (14) according to any of the claims 9 to 11, wherein each transient suppression segment (22.1, 22.2, 22.3) comprises at least one of the decoupling resistors (R4, R5, R6, R7) for decoupling the passive protection circuit unit (24.1, 24.2, 24.3) from the secondary capacitor (C3, C4, C5) during clamping.

13. Operation method for operating a circuit breaker (14) according to any of the claims 8 to 12, comprising the steps:
a) opening the main switch unit (16) in the event of a fault and applying an entire bus voltage to the clamping circuit (18); charging the primary (C1, C2) and the secondary capacitors (C3, C4, C5) until a steady state is reached;
b) closing the main switch unit (16) when the event of a fault is over and short-cutting the clamping circuit (18), discharging the secondary capacitors (C3, C4, C5) and discharging the primary capacitors (C1, C2) via the discharge circuit.

14. DC network (50) for an aircraft (100), comprising at least one source (10) of electrical energy and at least one sink (12) for electrical energy and at least one circuit breaker (14) according to any of the claims 1 to 12 connected between the at least one source (10) and the at least one sink (12).

15. Aircraft (100) comprising a DC network (50) according to claim 14 or at least one circuit breaker (14) according to any of the claims 1 to 12.
